# EUROPÄISCHE PATENTSCHRIFT

(11) **EP 2 058 076 B1**
(45) Veröffentlichungstag und Bekanntmachung des Hinweises auf die Patenterteilung: **07.05.2014**
(21) Anmeldenummer: 08022416.5
(22) Anmeldetag: 20.04.2007
(51) Int. Cl.: B23H 3/00, C25D 3/00

(54) **Verfahren zur Oberflächenbehandlung bei der Herstellung eines Presswerkzeuges aus Glaskohlenstoff zum Blankpressen von Linsen.**
Method for treating a surface during the production of a pressing tool made out off glasscarbon for the production of lenses.
Procédé de traitement de surface d'un outil en carbone pour la production de lentilles.

(30) Priorität: 21.04.2006 DE 102006019189; 30.06.2006 DE 102006030323
(43) Veröffentlichungstag der Anmeldung: 13.05.2009
(62) Teilanmeldung aus: 07724433.3
(73) Patentinhaber: Fraunhofer-Gesellschaft zur Förderung der angewandten Forschung e.V., 80686 München (DE)
(72) Erfinder: Quenzer, Hans-Joachim, 25524 Itzehoe (DE); Zwicker, Gerfried, 25524 Itzehoe (DE)
(74) Vertreter: Rösler, Uwe

(56) Entgegenhaltungen:
- US-A- 5 795 653
- US-A1- 2002 197 761

## Beschreibung

### Technisches Gebiet

Die Erfindung bezieht sich auf ein Verfahren zur Oberflächenbehandlung bei der Herstellung eines Presswerkzeuges aus Glaskohlenstoff zum Blankpressen von Linsen.

### Stand der Technik

Gattungsgemäße Verfahren zur Oberflächenbehandlung von elektrisch leitfähigen Substratoberflächen stellen entweder an sich bekannte Materialabtrageverfahren, wie beispielsweise nasschemische Ätztechniken, oder Materialabscheideverfahren dar, wie beispielsweise galvanische Verfahren, Sputter- oder Aufdampfverfahren, um nur einige zu nennen. In allen bekannten Verfahren gilt es an einer zu bearbeitenden Substratoberfläche für den jeweiligen Prozess erforderliche Prozessbedingungen zu schaffen, die zum Teil mit großem apparativen Aufwand und damit auch mit hohen Kostenaufwendungen verbunden sind. Beispielsweise gilt es zur Abscheidung von Materialschichten auf einer Substratoberfläche eine entsprechende Vakuumkammer bereitzuhalten, in der unter Vakuumbedingungen bestimmte Materialabscheidungen an der Substratoberfläche vorgenommen werden können. Der Einsatz nasschemischer Abscheideverfahren sowie auch Ätzverfahren setzt die Bereitstellung chemischer Bäder mit darin vorherrschenden elektrostatischen Bedingungen voraus, die neben dem hohen verfahrenstechnischem Aufwand auch zusätzliche Sicherheits- sowie auch Entsorgungsprobleme entstehen lassen.

Auch sind Planarisierungstechniken zur Einebnung von Substratoberflächen bekannt, die auf Basis chemisch mechanischen Polierens erfolgen, insbesondere von Cu-Oberflächen in der Mikroelektronik. Daneben können auch mit Hilfe des so genannten "Reverse Plating" durch Umkehrung eines galvanischen Abscheideprozesses überstehende Materialbereiche abgetragen werden. Auch diese Technik kann zur Einebnung von Materialabscheidungen eingesetzt werden.

Aus der US 5,795,653 ist ein Polierverfahren zur Herstellung hochplanarer Diamant- oder Kohlenstoffnitrid-Folien entnehmen, bei dem auf eine Oberfläche einer zu polierenden Diamant- oder Kohlenstoffnitrid-Folie ein Sauerstoffionen leitfähiges Planierungswerkzeug aus einem Yttrium stabilisierten Zirkonoxid aufgesetzt wird. Durch Anlegen einer elektrischen Spannung vermögen gelangen Sauerstoffionen an die Folienoberfläche an der durch Bildung von CO und CO2 Ätzprozesse initiiert werden.

### Darstellung der Erfindung

Der Erfindung liegt die Aufgabe zugrunde eine Oberflächenbehandlung an elektrisch leitfähigen Substratoberflächen zu ermöglichen, ohne dabei einen großen apparativen sowie auch kostenrelevanten Aufwand tragen zu müssen, wobei es gilt die Oberflächen zu strukturieren im Sinne einer lokalen Materialabtragung. Das lösungsgemäße Verfahren soll der Herstellung eines Presswerkzeuges aus Glaskohlenstoff zum Blankpressen von Linsen dienen.

Die der Erfindung zugrunde liegende Aufgabe wird durch ein im Anspruch 1 angegebenen Verfahren gelöst. Den Erfindungsgedanken vorteilhaft weiterbildende Merkmale sind Gegenstand der Unteransprüche sowie der weiteren Beschreibung insbesondere unter Bezugnahme auf das Ausführungsbeispiel zu entnehmen.

Bei dem lösungsgemäßen Verfahren zur Herstellung eines Presswerkzeuges aus Glaskohlenstoff zum Blankpressen von Linsen wird ein festes Ionen leitendes Material in Form von ZrO₂ aufweisendes Werkzeug wenigstens bereichsweise in Kontakt mit einer Substratoberfläche aus Glaskohlenstoff gebracht, das als anionischer Ionenleiter ausgebildet ist, eine strukturierte Werkzeugoberfläche aufweist, die auf die Substratoberfläche aufgesetzt wird, und an das ein elektrisches Potenzial angelegt wird, so dass aus dem anionischen lonenleiter Anionen in Bereichen austreten, in denen das Werkzeug mit der Substratoberfläche in Kontakt steht, und sich an der Substratoberfläche zu einer mit der Substratoberfläche reaktiven Verbindung umwandeln, wobei die sich dabei ausbildende reaktionsfähige Verbindung mit dem Glaskohlenstoff an der Substratoberfläche eine gasförmige Verbindung eingeht, wodurch ein lokal begrenzter Materialabtragsvorgang realisiert wird, durch den die Substratoberfläche gleichsam eines lokalen Ätzvorganges strukturiert wird.

Das lösungsgemäße Verfahren eröffnet somit in Abhängigkeit von dem zwischen der Substratoberfläche und dem Werkzeug angelegten elektrischen Potenzial sowie in Abhängigkeit von der Formbeschaffenheit des Werkzeuges, die letztlich Form und Größe der Kontaktbereiche zwischen Werkzeug und Substratoberfläche bestimmt, die Möglichkeit lokale Materialabtragungen an der Substratoberfläche vorzunehmen und dies ohne die Notwendigkeit der Schaffung verfahrenstechnisch komplizierter Prozessbedingungen sowie die hierfür erforderlichen apparativen Voraussetzungen. Vielmehr beruht die lösungsgemäße Oberflächenbehandlung auf rein elektrochemische Vorgänge.

Das Werkzeug, mit dem die lösungsgemäße Oberflächenbehandlung der Substratoberfläche durchgeführt wird, besteht aus einem festen ionenleitenden, in Form von ZrO₂ aufweisendes Material, das über eine der Substratoberfläche zugewandte Werkzeugoberfläche verfügt, die je nach Oberflächenbehandlungsziel geeignet strukturiert ausgebildet ist. Die Werkzeugoberfläche wird zur Oberflächenbehandlung fest auf die Substratoberfläche unter Ausbildung eines innigen, vorzugsweise kraftbeaufschlagten Flächenkontaktes angepresst. Zumindest die zu behandelnde Substratoberfläche enthält Glaskohlenstoff. Zwischen der Substratoberfläche und der Rückseite des aus Anionen leitendem Material bestehenden Werkzeuges wird im Weiteren eine geeignet gewählte elektrische Spannung angelegt.

Da das aus Anionen leitendem Material bestehende Werkzeug kraftbeaufschlagt gegen die Substratoberfläche gepresst wird, sinkt das Werkzeug kontinuierlich in die Substratoberfläche solange ein, solange der Ätzvorgang andauert, d.h. solange das Werkzeug kraftbeaufschlagt gegen die Substratoberfläche gepresst wird, während ein elektrisches Potenzial zwischen Substratoberfläche und Werkzeug anliegt. Wie bereits erwähnt kommt es im Unterschied zur Verwendung flüssiger Elektrolyte nur zu einem lokalen Ätzvorgang bzw. Materialabtrag im Kontaktbereich, d.h. in jenen Bereichen, in denen das Werkzeug im Flächenkontakt mit der Substratoberfläche steht. Besonders vorteilhaft ist es, wenn das aus Anionen leitende Material bestehende Werkzeug das zu ätzende Metall vollständig und rückstandsfrei zu transportieren vermag, so dass das Werkzeug keine Änderung hinsichtlich der chemischen Zusammensetzung erfährt.

Durch den Einsatz eines anionischen Ionenleiters als Werkzeugmaterial können an der Grenzfläche zwischen dem Werkzeug und der Substratoberfläche reaktive Gase, gegebenenfalls auch in atomarer Form auftreten, die unmittelbar zu einer chemischen Reaktion an der Grenzfläche zwischen dem aus Ionen leitenden Material bestehenden Werkzeug und der elektrisch leitenden Substratoberfläche führen. Treten derartige Reaktionsprodukte in gasförmiger Form, beispielsweise bei Verwendung von Fluorionenleitern auf, so kann dieser Prozess für lokale Ätzprozesse genutzt werden.

### Kurze Beschreibung der Erfindung

Die Erfindung wird nachstehend ohne Beschränkung des allgemeinen Erfindungsgedankens anhand eines Ausführungsbeispiels unter Bezugnahme auf die Zeichnung exemplarisch beschrieben. Es zeigt:

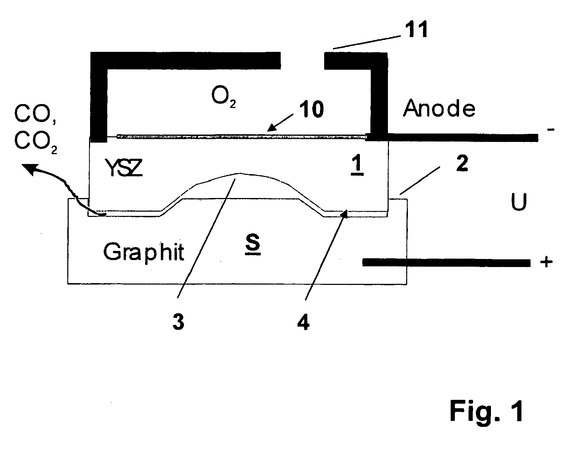

- Fig. 1: Ausführungsbeispiel zum lokalen Materialabtrag mittels eines anionischen Ionenleiters aus ZrO₂.

### Wege zur Ausführung der Erfindung, gewerbliche Verwendbarkeit

Unter Verwendung eines Sauerstoff leitenden Materials als Werkzeugmaterial, wie beispielsweise Zirkonium-Oxyd (ZrO₂) können Materialien wie Graphit oder Diamant dreidimensional strukturiert bzw. repliziert werden.

Besonders eignet sich als Werkzeugmaterial eine Yttrium stabilisiertes Zirkonoxidkeramik (YSZ). Der einfachste Aufbau ist in Figur 1 gezeigt, in der ein geeignet ausgeformtes Werkzeug 1 aus YSZ auf die Substratoberfläche 2 aus Graphit aufgesetzt ist. Die Ionenleitfähige Keramik wird rückseitig mit einer dünnen elektrisch leitfähigen Schicht 10, in diesem Fall aus Platin, beschichte, die dennoch hinreichend durchlässig für Sauerstoff bleibt.

Nach Aufsetzten des Werkzeuges 1 auf dem Graphit wird zwischen dem Graphit und der Rückseite des Werkzeuges eine Spannung U angelegt. Um eine ausreichende Ionische Leitfähigkeit der Keramik zu erreichen ist es notwenig die gesamte Anordnung auf eine Temperatur von ca. 400 °C in einer Sauerstoffhaltigen Atmosphäre aufzuheizen.

Unter diesen Bedingungen ist das Graphit gegenüber Sauerstoff einerseits noch stabil, anderseits aber besitzt die YSZ Keramik des Werkzeuges 1 eine ausreichende Leitfähigkeit und das Graphit ist hinreichen reaktiv um einen Ätzprozess in Gang zu bringen. Die Sauerstoffatmosphäre O₂ sorgt dabei für den eigentlichen Nachschub an Sauerstoff und verhindert die Ausbildung von Verarmungszonen im Ionenleiter. Unter diesen Bedingungen ist es bei einer Spannung um 80V und einer Stromdichte um 2 mA/cm² möglich, eine Ätzrate um 12 - 30 nm /min zu erreichen.
Eine deutlich größere Ätzrate ist allerdings erreichbar. wenn eine höhere Prozesstemperatur angewendet wird. Bei Temperaturen oberhalb von 500°C ist es allerdings unbedingt erforderlich das Graphit vor dem Sauerstoff zu schützten bzw. zu isolieren.

In diesem Fall wird das YSZ Werkzeug 1 rückseitig mit einer keramischen Zuleitung 11 verbunden, deren Innenvolumen mit einer Sauerstoffhaltigen Atmosphäre beaufschlagt wird. Der Raum außerhalb dieses Rohrs wird hingegen mit einem Schutzgas, Stickstoff oder Argon, gespült. Damit wird eine unerwünschte Reaktion des Graphits mit Sauerstoffresten weitgehend vermieden.

Um den lateralen Abtransport der Reaktionsprodukte, CO oder CO₂, insbesondere bei großflächigen Objekten zu erleichtern, kann unterstützend eine vertikale Vibrationsbewegung wie etwa Ultra- oder Megaschall eingeleitet werden.

Dieses Verfahren gilt der Herstellung oder Replikation von Presswerkzeugen aus Glaskohlenstoff. Diese Werkzeuge eignen sich als Formeneinsätze in Blankpressverfahren von Linsen für sehr hochschmelzende Werkstoffe wie Kieselglas.

### Bezugszeichenliste

- 1: Werkzeug
- 2: Substratoberfläche
- 3: konkav-förmige Ausnehmung
- 4: Umfangsrand
- S: Substrat
- A: Anode
- K: Kathode
- 10: Platinschicht
- 11: Keramische Zuleitung

## Patentansprüche

1. Verfahren zur Oberflächenbehandlung bei der Herstellung eines Presswerkzeuges aus Glaskohlenstoff zum Blankpressen von Linsen, bei dem ein festes Ionen leitendes Material in Form von ZrO₂ aufweisendes Werkzeug wenigstens bereichsweise in Kontakt mit einer Substratoberfläche aus Glaskohlenstoff gebracht wird, das als anionischer Ionenleiter ausgebildet ist, eine strukturierte Werkzeugoberfläche aufweist, die auf die Substratoberfläche aufgesetzt wird, und an das ein elektrisches Potenzial angelegt wird, so dass aus dem anionischen Ionenleiter Anionen in Bereichen austreten, in denen das Werkzeug mit der Substratoberfläche in Kontakt steht, und sich an der Substratoberfläche zu einer mit der Substratoberfläche reaktiven Verbindung umwandeln, wobei die reaktionsfähige Verbindung mit dem Glaskohlenstoff an der Substratoberfläche eine gasförmige Verbindung eingeht, wodurch ein lokal begrenzter Materialabtragsvorgang realisiert wird, durch den die Substratoberfläche gleichsam eines lokalen Ätzvorganges strukturiert wird.

2. Verfahren nach Anspruch 1,
**dadurch gekennzeichnet, dass** das Werkzeug kraftbeaufschlagt auf die Substratoberfläche gepresst wird.

3. Verfahren nach Anspruch 1 oder 2,
**dadurch gekennzeichnet, dass** das Werkzeug eine der Substratoberfläche zugewandte und abgewandte Seite aufweist, und
dass das elektrische Potenzial zwischen der Substratoberfläche und der der Substratoberfläche abgewandte Seite des Werkzeuges angelegt wird.

4. Verfahren nach einem der Ansprüche 1 bis 3,
**dadurch gekennzeichnet, dass** das Anionen leitende Material des Werkzeuges derart ausgewählt wird, dass die von der Substratoberfläche aufgenommenen Anionen ausschließlich durch das Werkzeug transportiert werden ohne dessen chemische Zusammensetzung zu verändern.

5. Verfahren nach einem der Ansprüche 1 bis 4,
**dadurch gekennzeichnet, dass** als Reservoir an der der Substratoberfläche abgewandten Seite des Werkzeuges ein die Anionen abgebendes gasförmiges Reservoir vorgesehen wird.

6. Verfahren nach Anspruch 5,
**dadurch gekennzeichnet, dass** das Reservoir an der der Substratoberfläche abgewandten Seite des Werkzeuges räumlich von dem Substrat gasdicht getrennt ist.

7. Verfahren nach einem der Ansprüche 1 bis 6,
**dadurch gekennzeichnet, dass** das Werkzeug und/oder die Substratoberfläche Vibrationen ausgesetzt wird, so dass die sich zwischen der Werkzeugoberfläche und der Substratoberfläche ausbildende gasförmige Verbindung entweicht.

## Claims

1. A method for surface treatment in the production of a pressing tool made from glassy carbon for moulding lenses, in which a tool having a solid, ion-conducting material in the form of ZrO₂ is brought into contact at least with portions of a substrate surface of glassy carbon, which is in the form of an anionic ion conductor, has a structured tool surface that is placed on the substrate surface and to which an electric potential is applied, so that anions escape at areas of the anionic ion conductor in which the tool is in contact with the substrate surface, and are converted into a compound that reacts with the substrate surface, wherein the reactive compound combines with the glassy carbon on the substrate surface to form a gaseous compound via which a locally limited material removal action is effected, by which the substrate surface is structured in a manner similar to a localised etching process.

2. The method according to claim 1,
**characterized in that** the tool is pressed against the substrate surface by the application of a force.

3. The method according to claim 1 or 2,
**characterized in that** the tool has one side closest to the substrate surface and one side farthest from the substrate surface, and
that the electric potential is applied between the substrate surface and the side of the tool farthest from the substrate surface.

4. The method according to any of claims 1 to 3,
**characterized in that** the anion conducting material of the tool is selected such that the anions taken up by the substrate surface are transported exclusively via the tool, without changing the chemical composition thereof.

5. The method according to any of claims 1 to 4,
**characterized in that** a gas-phase reservoir that emits the anions is provided as a reservoir on the side of the tool farthest from the substrate surface.

6. The method according to claim 5,
**characterized in that** the reservoir on the side of the tool farthest from the substrate surface is separated spatially from the substrate in gas-tight manner.

7. The method according to any of claims 1 to 6,
**characterized in that** the tool and/or the substrate surface is exposed to vibrations, such that the gaseous compound that forms between the tool surface and the substrate surface escapes.

## Revendications

1. Procédé pour le traitement de surface lors de la fabrication d'un outil de pressage en carbone vitreux pour le pressage à blanc de lentilles, dans lequel un outil présentant un matériau solide conduisant des ions sous la forme de ZrO₂ est mis en contact, au moins par endroits, avec une surface de substrat en carbone vitreux, lequel est réalisé en tant que conducteur d'ions anionique, présente une surface d'outil structurée qui est apposée sur la surface du substrat, et auquel un potentiel électrique est appliqué, de sorte que des anions sortent du conducteur anionique dans des zones dans lesquelles l'outil est en contact avec la surface du substrat et se transforment à la surface du substrat en une combinaison réactive avec la surface du substrat, moyennant quoi la combinaison à capacité de réaction forme, avec le carbone vitreux, une combinaison gazeuse à la surface du substrat, de sorte qu'un processus d'enlèvement de matériau limité localement est réalisé, grâce auquel la surface du substrat est structurée quasiment à la manière d'un processus de décapage.

2. Procédé selon la revendication 1,
**caractérisé en ce que** l'outil est pressé par application d'une force sur la surface du substrat.

3. Procédé selon les revendications 1 ou 2,
**caractérisé en ce que** l'outil présente un côté orienté vers la surface du substrat et un côté tournant le dos à celle-ci, et
**en ce que** le potentiel électrique est appliqué entre la surface du substrat et le côté de l'outil tournant le dos à la surface du substrat.

4. Procédé selon l'une des revendications 1 à 3,
**caractérisé en ce que** le matériau conduisant les anions de l'outil est sélectionné de manière à ce que les anions absorbés par la surface du substrat soient exclusivement transportés par l'outil sans modifier la composition chimique de celui-ci.

5. Procédé selon l'une des revendications 1 à 4,
**caractérisé en ce que**, en guise de réservoir, on prévoit un réservoir de forme gazeuse délivrant les anions sur le côté de l'outil tournant le dos à la surface du substrat.

6. Procédé selon la revendication 5,
**caractérisé en ce que** le réservoir est séparé spacialement du substrat de manière étanche aux gaz sur le côté de l'outil tournant le dos à la surface du substrat.

7. Procédé selon l'une des revendications 1 à 6,
**caractérisé en ce que** l'outil et/ou la surface du substrat sont exposés à des vibrations, de sorte que la combinaison gazeuse se formant entre la surface de l'outil et la surface du substrat s'échappe.
